# EUROPEAN PATENT SPECIFICATION

(11) **EP 2 138 818 B1**
(45) Date of publication and mention of the grant of the patent: **27.11.2013**
(21) Application number: 09162800.8
(22) Date of filing: 16.06.2009
(51) Int. Cl.: G01J 5/20, G01J 5/22

(54) **Bolometer comprising an active layer surrounded on both sides by a contact layer and with an electrode layer.**
Bolometer mit einer aktiven Schicht, die an beiden Seiten von einer Kontaktschicht und Elektrodenschicht umgeben ist.
Bolometer comprenant une couche active entourée des deux côtés par une couche de contact avec une couche d'électrodes

(30) Priority: 25.06.2008 SE 0801497
(43) Date of publication of application: 30.12.2009
(73) Proprietor: Acreo Swedish ICT AB, 164 40 Kista (SE)
(72) Inventor: Vieider, Christian, 752 36, Uppsala (SE); Ericsson, Per, 175 67, JÄRFÄLLA (SE)
(74) Representative: Haag, Malina Anna

(56) References cited:
- US-A- 5 998 791
- Stanley Wissmar ET AL: "High signal-to-noise ratio quantum well bolometer materials", Proceedings of SPIE, vol. 6401, 1 January 2006 (2006-01-01), pages 64010N-64010N-11, XP055013321, ISSN: 0277-786X, DOI: 10.1117/12.689874

## Description

The present invention relates to a semiconductor component comprising an active layer surrounded on both sides by a contact layer and with an electrode layer.

The present invention can be used for different semiconductor components that have an extension in the plane of the layer that is greater than their dimension perpendicular to the said plane. It is exemplified in the description below, however, by a bolometer.

US 5,998,791 shows a thermally sensitive element comprising a sensitive disc made from a carbonised sheet material. On top of said disc there is a conductive layer and the bottom of said disc there are two electrodes that are spaced apart in order to increase the resistance between the electrodes.

A bolometer, for example, is built up of a number of layers, which may, for example, be alternating layers of Si and layers of SiGe, which have an extension in the plane of the layers that is greater than their dimension perpendicular to this plane. The layers may also be GaAs/InGaAs or GaAs/ AlGaAs. An electrode layer is present on each of the two sides of such a structure, which electrode layer is connected to electrical conductors. A bolometer may be used, for example, as an IR detector element in a camera.

The transport of current must take place vertically, i.e. across the plane of the layers, due to its construction as a multilayer structure with anisotropic properties. A limiting fact for such a structure is that the resistivity of the active layer cannot easily be freely chosen relative to other properties, such as, for example, temperature sensitivity.

A number of detector elements is placed into a matrix in an imaging detector, where the CC-distances between the detector elements is determined by the optical design and by the cost of components.

In order to achieve as high a signal/noise ratio as possible, the electrical circuit that reads the detectors must be optimised relative to both the detector and the manufacturing process that is to be used.

There have been until now only few possibilities to influence the electrical properties of the detector once the optical properties have been determined, since the electrical properties have been dictated by the geometrical dimensions.

The present invention solves this problem and makes it possible to choose more easily the electrical properties independently of the geometrical dimensions.

The present invention thus relates to a semiconductor component comprising a first, active, layer comprising one or several electrically conducting layers embedded on both sides by a first and a second layer respectively, which second first and second layers are contact layers, comprising one or several electrically conducting layers, where the active layer has an electrical conductivity that is lower than the conductivity in the contact layers, and where an electrode layer is present, connected to a first of the contact layers, and where the semiconductor component has greater dimensions in the lateral direction, i.e. parallel to the plane of the layers, than in the direction perpendicular to said plane, where the electrodes have an extension in the lateral direction that is less than the lateral dimensions of the semiconductor component, where a groove is present which passes through said first of the contact layers, and where electrodes are present on both sides of the groove, characterised in that the active layer is a thermistor layer comprising alternate quantum well layers or quantum dots and barrier layers in that each one of the electrodes on the upper contact layer has a surface area that is less than 10% of the surface area of the semiconductor component and in that the magnitude of the surface area of the upper contact layer relative to the magnitude of the upper surface area of the semiconductor component has been adapted to give the semiconductor component a predetermined electrical resistance.

The invention is described in more detail below, partially in association with embodiments shown in the attached drawings, where:
- Figure 1 shows an IR detector structure according to prior art technology,
- Figure 2 also shows an IR detector structure according to prior art technology,
- Figure 3 shows an IR detector structure according to a first embodiment of the invention,
- Figure 4 shows an IR detector structure according to a second embodiment of the invention, and
- Figure 5 shows an IR detector structure according to a third embodiment of the invention.

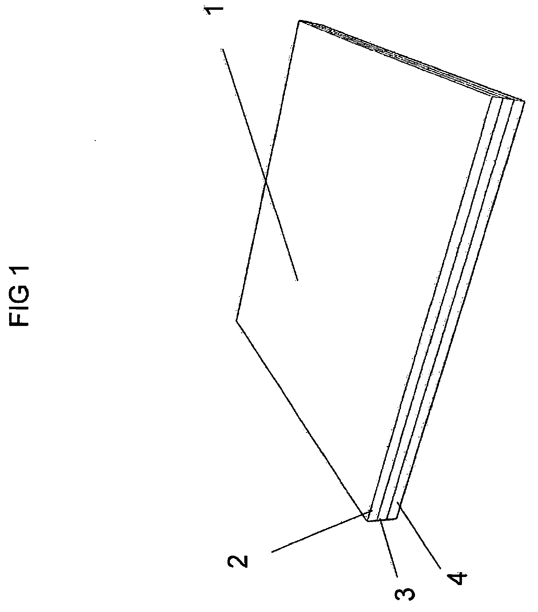

Figure 1 shows a semiconductor component 1 comprising a first, active, layer 3 comprising one or several electrically conducting layers embedded on both sides by a second layer, a contact layer 2, 4, comprising one or several electrically conducting layers. The active layer 3 has an electrical conductivity that is lower than the conductivity in the contact layers 2, 4. An electrode layer is present, not shown in the drawings, connected to at least one of the contact layers 2, 4. The electrode layers normally have an extension that is less than the extension of the contact layers. Furthermore, the semiconductor component 1 has greater dimensions in the lateral direction, i.e. in the plane of the layers, than it has in the direction perpendicular to this plane.

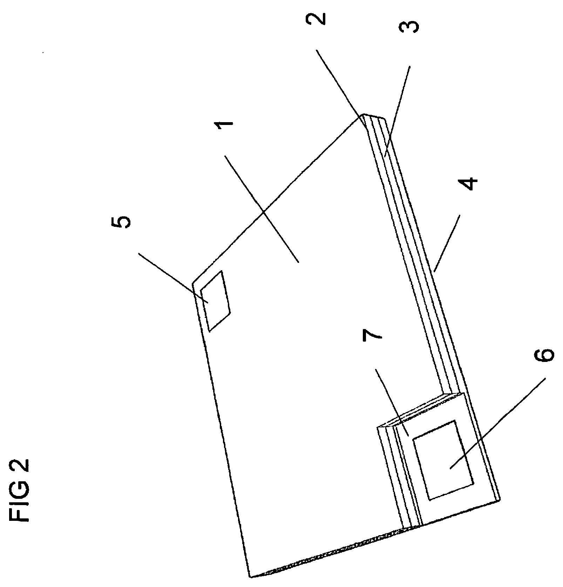

In a design according to prior art technology, shown in Figure 2, the groove 7 passes through all layers 2, 3, 4 such that a lower 6 of the electrodes is exposed. This makes it possible for the component to be connected through the lower electrode 6 and the upper electrode 5. The electrical resistance between the two electrodes 5, 6 is thus determined by the resistivity of the active layer 3, the surface area of the electrodes, and the thickness of the active layer.

According to the invention, the electrodes have an extension in the lateral direction that is less than the lateral dimensions of the semiconductor component. Furthermore, a groove 10; 14; 17 is present through at least the upper 2 of the contact layers. Furthermore, electrodes 8,9; 12,13; 15,16 are present on both sides of the groove, where it is intended that the semiconductor component be connected through the electrodes.

According to one embodiment, the active layer 3 is a temperature-sensitive layer.

According to a further embodiment, the active layer 3 is a thermistor layer comprising alternate quantum well layers or quantum dots and barrier layers.

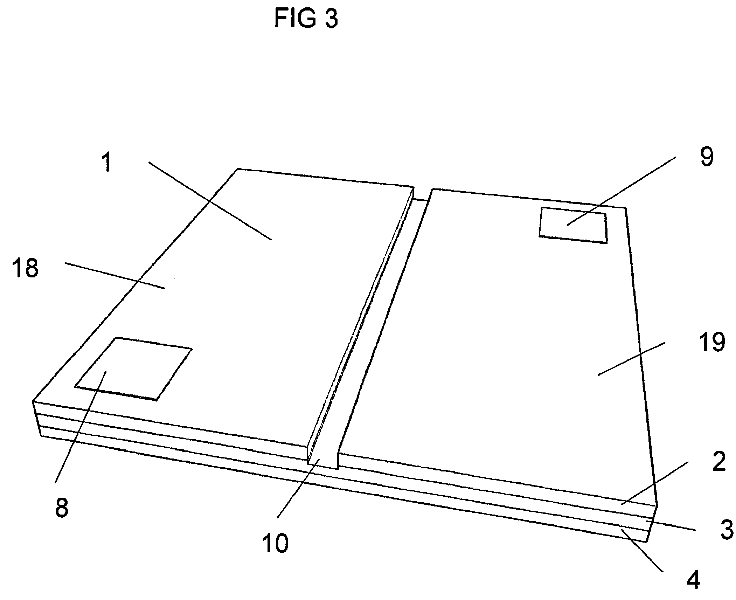

According to a first embodiment of the invention shown in Figure 3, the groove 10 passes through the upper layer 2 of the contact layers. In this way an upper electrode 8, 9 is present on each side of the groove. According to this embodiment, two separate electrodes 8, 9 are formed on the same side of the component 1. The electrical current is spread over the complete area of one of the upper contact layers such that it flows down to the lower contact layer 4 and subsequently up to the second upper contact layer 19. The resistance in this embodiment will be approximately four times higher than it would be according to the embodiment shown in Figure 2. The resistance, however, still depends on the size of the pixels, i.e. the lateral size of the IR structure 1, which is determined by the optical properties.

The fact is exploited in the present invention that the detector material consists of a multilayer structure in which the electrical conductivity differs significantly between the contact layers 2, 4 and the active layer 3, and the fact that the lateral dimensions are significantly greater than the vertical dimensions, i.e. the dimensions perpendicular to the plane of the structure. One consequence of this will be that the transport of current through the active layer 3 will be essentially limited to the volume that lies between the surrounding contact layers 2, 4. The region between these is inactive from an electrical point of view. By selectively removing one or both of the contact layers 2, 4 it is possible to control the electrically active volume such that it is a fraction of the total volume while retaining the lateral dimensions.

The freeing of the dependency of the electrical properties and the optical properties has in this way been achieved. Separate optimisation of the optical and the electrical properties becomes in this way possible.

The lateral dimensions of the structure in figure 3 may be 30 micrometers. The length of one edge of the square electrodes 8, 9 may be 3 micrometers.

According to one preferred embodiment, the upper contact layer has a surface area that is less than 10% of the surface area of the semiconductor component.

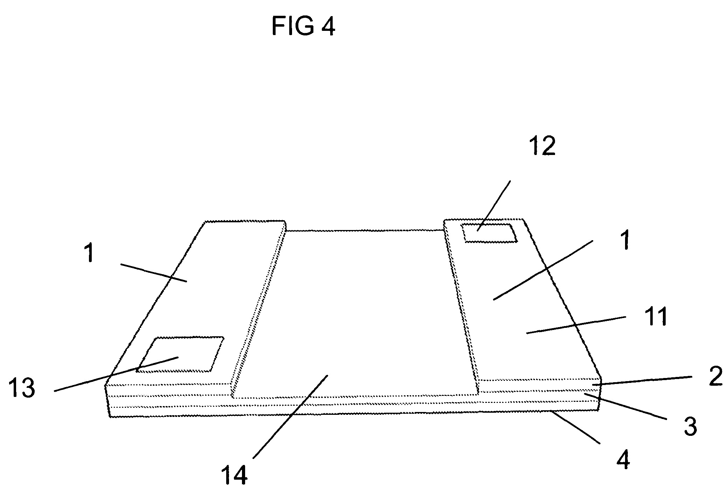

Figure 4 shows a second embodiment of the invention. The groove 14 in this embodiment is relatively broad, which leads to the active volume being significantly lower than the volume according to the said second embodiment, with the consequence that the resistance is correspondingly higher. The surface area of the pixel, however, is the same as previously. It is thus possible to optimise the resistance separately from the size of the pixel by adapting the area at the upper contact layer 2.

According to one preferred embodiment, the said groove 17 is designed such that a lattice of the upper contact layer is formed, which lattice is arranged to increase the optical absorption of incident light that impinges onto the semiconductor component.

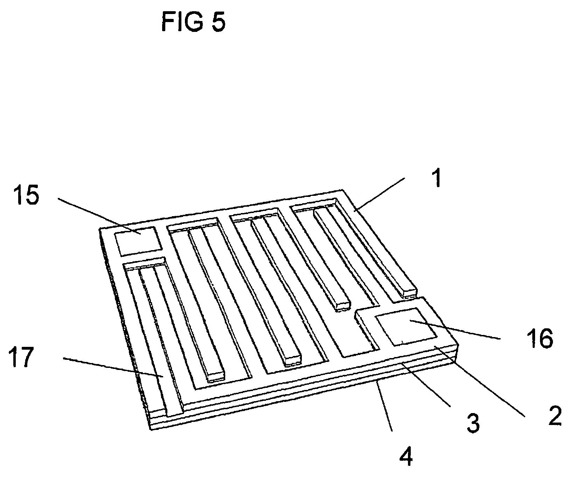

Figure 5 shows this third embodiment of the invention. According to this embodiment, the groove 17 is so designed that an interlace pattern of the upper contact layer 2 is formed. An optical lattice effect is in this way achieved, in addition to the ability to control the electrical resistance, such that the absorption of incident light increases.

A number of embodiments have been described above. It is, however, obvious that one skilled in the art can vary not only the amount of the upper contact layer that is to be removed, but also its form.

The present invention is defined by the attached patent claims.

## Claims

1. A semiconductor bolometer (1) comprising a first, active, layer (3) comprising one or several electrically conducting layers embedded on both sides by a first and a second contact layer (2, 4) respectively, comprising one or several electrically conducting layers, where the active layer (3) has an electrical conductivity that is lower than the conductivity in the contact layers (2, 4), and where an electrode layer is present, connected to a first of the contact layers, and where the semiconductor bolometer (1) has greater dimensions in the lateral direction, i.e. parallel to the plane of the layers, than in the direction perpendicular to said plane, where the electrodes (8, 9; 12, 13; 15, 16) have an extension in the lateral direction that is less than the lateral dimensions of the semiconductor bolometer (1), where a groove (10; 14; 17) is present which passes through said first (2) of the contact layers, and where separate electrodes (8, 9; 12, 13; 15, 16) are present on both sides of the groove (10; 14; 17), **characterised in that** the active layer (3) is a thermistor layer comprising alternate quantum well layers or quantum dots and barrier layers **in that** each one of the electrodes (8, 9; 12, 13; 15, 16) on the upper contact layer (2) has a surface area that is less than 10% of the surface area of the semiconductor bolometer (1) and **in that** the groove is designed such that the magnitude of the surface area of the upper contact layer (2) relative to the magnitude of the upper surface area of the semiconductor bolometer has been adapted to give the semiconductor bolometer (1) a predetermined electrical resistance so that the transport of current through the active layer (3) is essentially limited to the volume that lies between the surrounding contact layers (2,4).

2. A semiconductor bolometer according to claim 1, **characterised in that** the said groove (17) is designed such that a lattice of the upper contact layer (2) is formed, which lattice is arranged to increase the optical absorption of incident light that impinges onto the semiconductor bolometer (1).

## Patentansprüche

1. Halbleiterbolometer (1), das einen erste, aktive Schicht (3) umfasst, die eine oder mehrere elektrisch leitende Schichten umfasst, in die auf beiden Seiten eine erste bzw. eine zweite Schicht (2, 4) eingebettet ist, die eine oder mehrere elektrisch leitende Schichten umfasst, wobei die aktive Schicht (3) eine elektrische Leitfähigkeit aufweist, die geringer ist als die Leitfähigkeit in den Kontaktschichten (2, 4), und wobei eine Elektrodenschicht vorhanden ist, die mit einer ersten der Kontaktschichten verbunden ist, und wobei das Halbleiterbolometer (1) größere Abmessungen in der seitlichen Richtung aufweist, d. h. parallel zu der Ebene der Schichten, als in der Richtung senkrecht zu der Ebene, wobei die Elektroden (8, 9; 12, 13; 15, 16) eine Erstreckung in der seitlichen Richtung aufweisen, die kleiner ist als die seitlichen Abmessungen des Halbleiterbolometers (1), wobei eine Rille (10; 14; 17) vorhanden ist, die durch die erste (2) der Kontaktschichten hindurch verläuft, und wobei separate Elektroden (8, 9; 12, 13; 15, 16) auf beiden Seiten der Rille (10; 14; 17) vorhanden sind, **dadurch gekennzeichnet, dass** die aktive Schicht (3) eine Thermistorschicht ist, die im Wechsel Quantenmuldenschichten oder Quantenpunkte und Sperrschichten umfasst; dass jede der Elektroden (8, 9; 12, 13; 15, 16) auf der oberen Kontaktschicht (2) eine Oberfläche aufweist, die weniger als 10 % der Oberfläche des Halbleiterbolometers (1) beträgt; und dass die Rille so ausgeführt ist, dass die Größenordnung der Oberfläche der oberen Kontaktschicht (2) relativ zu der Größenordnung der oberseitigen Fläche des Halbleiterbolometers dafür ausgelegt wurde, dass das Halbleiterbolometer (1) einen vorgegebenen elektrischen Widerstand erhält, so dass der Transport von Strom durch die aktive Schicht (3) im Wesentlichen auf das Volumen begrenzt ist, das sich zwischen den umgebenden Kontaktschichten (2, 4) befindet.

2. Halbleiterbolometer nach Anspruch 1, **dadurch gekennzeichnet, dass** die Rille (17) so konfiguriert ist, dass ein Gitter der oberen Kontaktschicht (2) gebildet wird, wobei das Gitter dafür ausgelegt ist, die optische Absorption von einfallendem Licht, das auf das Halbleiterbolometer (1) auftrifft, zu erhöhen.

## Revendications

1. Bolomètre à semi-conducteurs (1) comprenant une première couche active (3) comprenant une ou plusieurs couches électriquement conductrices encastrées des deux côtés respectivement par des première et deuxième couches de contact (2, 4), comprenant une ou plusieurs couches électriquement conductrices, où la couche active (3) a une conductivité électrique inférieure à la conductivité dans les couches de contact (2, 4), et où une couche d'électrodes est présente, reliée à une première des couches de contact, et où le bolomètre à semi-conducteurs (1) a des dimensions supérieures dans la direction latérale, c'est-à-dire parallèle au plan des couches, que dans la direction perpendiculaire au dit plan, où les électrodes (8, 9 ; 12, 13 ; 15, 16) ont une extension dans la direction latérale inférieure aux dimensions latérales du bolomètre à semi-conducteurs (1), où une rainure (10 ; 14 ; 17) est présente et passe à travers ladite première (2) des couches de contact, et où des électrodes distinctes (8, 9 ; 12, 13 ; 15, 16) sont présentes des deux côtés de la rainure (10 ; 14 ; 17), **caractérisé en ce que** la couche active (3) est une couche de thermistance comprenant des couches de puits quantiques ou des points quantiques et des couches de barrière en alternance, **en ce que** chacune des électrodes (8, 9 ; 12, 13 ; 15, 16) sur la couche de contact supérieure (2) a une zone de surface qui est inférieure à 10 % de la zone de surface du bolomètre à semi-conducteurs (1) et **en ce que** la rainure est conçue de sorte que la grandeur de la zone de surface de la couche de contact supérieure (2) par rapport à la grandeur de la zone de surface supérieure du bolomètre à semi-conducteurs soit apte à donner au bolomètre à semi-conducteurs (1) une résistance électrique prédéterminée, afin que le transport du courant à travers la couche active (3) soit essentiellement limité au volume se trouvant entre les couches de contact environnantes (2, 4).

2. Bolomètre à semi-conducteurs selon la revendication 1, **caractérisé en ce que** ladite rainure (17) est conçue de manière à former un treillis de la couche de contact supérieure (2), lequel treillis étant agencé pour augmenter l'absorption optique de la lumière incidente qui empiète sur le bolomètre à semi-conducteurs (1).
